# EUROPEAN PATENT APPLICATION

(11) **EP 4 697 866 A1**
(43) Date of publication of application: **18.02.2026**
(21) Application number: 25192097.1
(22) Date of filing: 28.07.2025
(51) Int. Cl.: H05K 1/02

(54) **PRINTED CIRCUIT BOARD HEAT EXCHANGER AND ASSOCIATED METHOD**

(30) Priority: 13.08.2024 US 202418802828
(71) Applicant: STMicroelectronics International N.V., 1228 Plan-les-Ouates, Geneva (CH)
(72) Inventor: HALLIDAY, William, Edinburgh, EH12 8EX (GB)
(74) Representative: Buzzi, Notaro & Antonielli d'Oulx S.p.A.

(57) **Abstract**

In accordance with various embodiments of the present disclosure, a printed circuit board (100), PCB is provided that comprises a core layer (102), a plurality of prepreg layers (106, 114), a plurality of electrically conducting layers (104, 108, 112, 116) for carrying electrical signals and/or for providing a ground plane, a first heat conducting layer (130) positioned to receive heat dissipated from one or more components (122) attached to a surface of the PCB (100), a second heat conducting layer (132) positioned on an opposite side of one of the electrically conducting layers (104, 108, 112, 116) from the first heat conducting layer (130), and a plurality of heat conducting vias (134). The first heat conducting layer (130) is electrically isolated from all of the electrically conducting layers (104, 108, 112, 116). The second heat conducting layer (132) is electrically isolated from all of the electrically conducting layers (104, 108, 112, 116). The heat conducting vias (134) are connected between the first (130) and second (132) heat conducting layers and are electrically isolated from all of the electrically conducting layers (104, 108, 112, 116).

## Description

### FIELD OF THE INVENTION

Example embodiments of the present disclosure relate generally to printed circuit boards and, more particularly, to heat dissipation within printed circuit boards.

### BACKGROUND

Heat generated by high-power electronic components on printed circuit boards (PCBs) often must be dissipated to ensure proper performance and reliability. Often this involves dissipating heat into one or more ground planes within the PCB and from the ground plane(s) to a heat sink.

However, for some components (such as light emitting diodes (LEDs) and vertical-cavity surface-emitting lasers (VCSELs)), heat is dissipated through their bottom side which is a cathode and which therefore must be electrically isolated from the ground planes of the PCB. Thus, for such components, the heat must be dissipated in a way that maintains the required electrical isolation of the bottom side (cathode) of the component.

Applicant has identified many technical challenges and difficulties associated with heat dissipation within PCBs. Through applied effort, ingenuity, and innovation, Applicant has solved problems related to heat dissipation within PCBs by developing solutions embodied in the present disclosure, which are described in detail below.

### BRIEF SUMMARY

Various embodiments described herein related to printed circuit boards and methods for fabricating printed circuit boards to provide heat dissipation.

In accordance with various embodiments of the present disclosure, a printed circuit board is provided that comprises a core layer, a plurality of prepreg layers, a plurality of electrically conducting layers for carrying electrical signals and/or for providing a ground plane, a first heat conducting layer positioned to receive heat dissipated from one or more components attached to a surface of the printed circuit board, a second heat conducting layer positioned on an opposite side of one of the plurality of electrically conducting layers from the first heat conducting layer, and a first plurality of heat conducting vias. The first heat conducting layer is electrically isolated from all of the plurality of electrically conducting layers. The second heat conducting layer is electrically isolated from all of the plurality of electrically conducting layers. Each of the first plurality of heat conducting vias are connected between the first heat conducting layer and the second heat conducting layer. Each of the first plurality of heat conducting vias are electrically isolated from all of the plurality of electrically conducting layers.

In some embodiments, the first and second heat conducting layers are each electrically isolated from all of the plurality of electrically conducting layers by the core layer and/or one or more of the plurality of prepreg layers.

In some embodiments, at least some of the first plurality of heat conducting vias extend through corresponding holes defined in one or more of the plurality of electrically conducting layers.

In some embodiments, the printed circuit board further comprises a third heat conducting layer positioned on an opposite side of a second one of the plurality of electrically conducting layers from the second heat conducting layer and a second plurality of heat conducting vias. The third heat conducting layer is electrically isolated from all of the plurality of electrically conducting layers. Each of the second plurality of heat conducting vias are connected between the second heat conducting layer and the third heat conducting layer. Each of the second plurality of heat conducting vias are electrically isolated from all of the plurality of electrically conducting layers.

In some embodiments, the second and third heat conducting layers are each electrically isolated from all of the plurality of electrically conducting layers by the core layer and/or one or more of the plurality of prepreg layers.

In some embodiments, at least some of the second plurality of heat conducting vias extend through corresponding holes defined in one or more of the plurality of electrically conducting layers.

In some embodiments, the printed circuit board further comprises a plurality of electrically conducting vias connected between corresponding ones of the plurality of electrically conducting layers. At least some of the plurality of electrically conducting vias extend through corresponding holes defined in the second heat conducting layer.

In accordance with various embodiments of the present disclosure, a method of manufacturing a printed circuit board is provided. In some embodiments, the method comprises forming a stack comprising a core layer, a plurality of prepreg layers, and a plurality of electrically conducting layers for carrying electrical signals and/or for providing a ground plane; forming a first heat conducting layer within the stack such that the first heat conducting layer receives heat dissipated from one or more components attached to a surface of the printed circuit board and such that the first heat conducting layer is electrically isolated from all of the plurality of electrically conducting layers; forming a second heat conducting layer within the stack on an opposite side of one of the plurality of electrically conducting layers from the first heat conducting layer and such that the second heat conducting layer is electrically isolated from all of the plurality of electrically conducting layers; and forming a first plurality of heat conducting vias connected between the first heat conducting layer and the second heat conducting layer, such that each of the first plurality of heat conducting vias are electrically isolated from all of the plurality of electrically conducting layers.

In accordance with various embodiments of the present disclosure, a photonic sensor is provided that comprises a printed circuit board (PCB) as described above having a light producing component mounted thereto.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a cross-sectional view of an example portion of a printed circuit board, in accordance with some embodiments of the present disclosure; and
FIG. 2 is a cross-sectional view of an example portion of a printed circuit board, in accordance with some alternative embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Various embodiments of the present disclosure overcome the above technical challenges and difficulties and provide various technical improvements and advantages based on, for example, but not limited to, providing an effective thermal management solution for devices such as VCSELs and LEDs in photonics packages that require electrical isolation for electrical design and safety reasons. Various embodiments of the present disclosure utilize the stacked nature of PCB substrates to interleave heat-bearing copper layers (connected to the cathode of devices such as VCSELs/LEDs) with heat-sinking copper layers (typically connected to ground) to increase the effective area through which heat can pass between the heat-bearing and heat-sinking layers.

In some embodiments, sandwiching a ground plane between two or more heat conducting layers (both heat conducting layers connected (directly or indirectly) to the cathode of the device) approximately doubles (or more) the effective surface area through which heat can be conducted between the cathode and the ground. Various embodiments of the present disclosure use, for example, plated through-hole vias or micro-vias in the cathode pad of the device to conduct heat from device to the heat conducting layers. Various embodiments of the present disclosure use vias to distribute heat evenly throughout the heat-bearing layers. In some embodiments of the present disclosure, vias are used to distribute heat evenly through the heat-sinking layers.

Various embodiments of the present disclosure rely on the high thermal conduction of the copper used in the metal layers of PCB substrates as a means to move heat around efficiently. Various embodiments of the present disclosure provide a cost-effective heat management solution as the heat conducting surfaces and vias are formed as part of PCB substrate fabrication. In various embodiments, heat exchange geometry can be controlled to suit the PCB layout and construction. In various embodiments, the stack order can be adjusted to bypass the poor thermal conductivity of thicker substrate cores. In various embodiments, the use of the prepreg laminates between the cathode/ground sandwiches is preferred for lowest thermal resistance.

Various embodiments of the present disclosure provide an alternative thermal management solution well suited for highly integrated, low-cost photonic products where ceramic interposers or heatsinks are too expensive or impractical for other reasons.

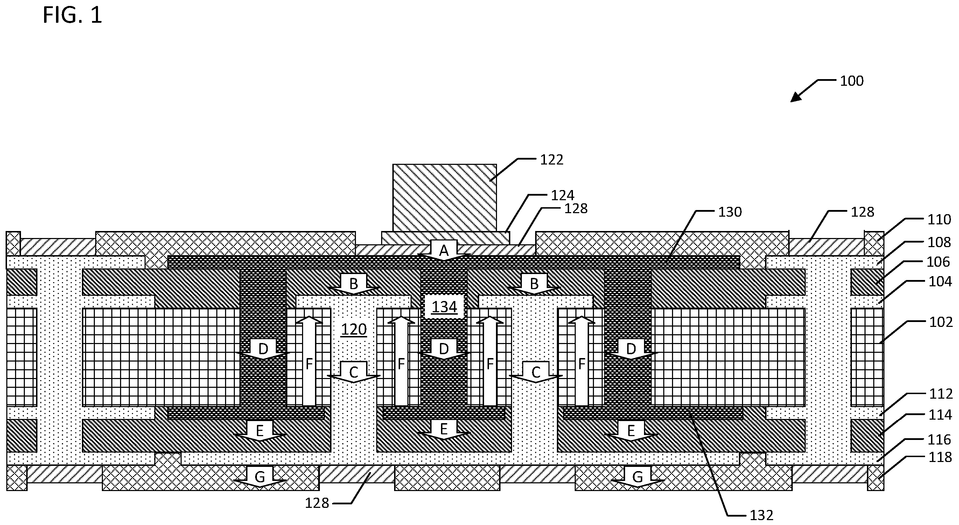

FIG. 1 illustrates a cross-sectional view of an example PCB, in accordance with some embodiments of the present disclosure. As seen in FIG. 1, an example PCB 100 comprises a core layer (or simply "core") 102, a first top electrically conducting layer 104, a top prepreg layer 106, a second top electrically conducting layer 108, a top solder mask 110, a first bottom electrically conducting layer 112, a bottom prepreg layer 114, a second bottom electrically conducting layer 116, and a bottom solder mask 118. In various embodiments, more or fewer layers may be present. In various embodiments, the layers may be in a different order than is illustrated. In various embodiments, the core 102 comprises any suitable material, such as FR4. In various embodiments, the prepreg layers 106, 114 comprise any suitable material, such as fiberglass impregnated with resin. In various embodiments the electrically conducting layers 104, 108, 112, 116 comprise any suitable conductive material, such as copper. In various embodiments the electrically conducting layers 104, 108, 112, 116 carry electrical signals and/or provide a ground plane. Two or more of the electrically conducting layers may be connected to each other using one or more vias. In the illustrated embodiment, there are two vias 120 connecting the first top electrically conducting layer 104 to the second bottom electrically conducting layer 116. As described further below, heat may be conducted within the PCB 100 through these vias 120.

As illustrated in FIG. 1, the top solder mask 110 and the bottom solder mask 118 may be etched away in one or more locations to expose, respectively, the topmost electrically conducting layer 108 and the second bottom electrically conducting layer 116. In such areas, a protective plating 128 (e.g., nickel or gold) is applied over the exposed areas of the electrically conducting layers. As illustrated in FIG. 1, the top solder mask 110 is etched away to expose the first heat conducting layer 130 (discussed below). The protective plating 128 is applied over this area as well. As illustrated in FIG. 1, an electronic component 122 is mounted to a top surface of the PCB 100 (using, e.g., solder or a conductive adhesive). In various embodiments, the electronic component 122 comprises an LED, VCSEL, or the like which requires heat be dissipated through its bottom side (e.g, cathode pad, not visible in FIG. 1) and which must be electrically isolated from the ground planes of the PCB 100. In various embodiments, the electronic component 122 is secured to the PCB 100 using a conductive adhesive 124 (or a conductive solder) which provides both an electrical and a thermal interface between the electronic component 122 and the PCB 100. In various embodiments, heat generated in the electronic component 122 is conducted through the cathode pad and through the conductive adhesive 124 to the heat conducting layers (described further below). In various embodiments, a PCB comprises two or more heat conducting layers that enable heat transfer from the electronic component to one or more of the electrically conducting layers and ultimately out of the PCB. While the heat conducting layers and the electrically conducting layers may comprise the same material (e.g., copper) and may, in fact, be constructed from the same physical layers of the PCB, all of the heat conducting layers are electrically isolated from all of the electrically conducting layers. This electrical isolation between the heat conducting layers and the electrically conducting layers ensures that the electronic component is properly isolated.

As illustrated in FIG. 1, the PCB 100 comprises a first heat conducting layer 130 and a second heat conducting layer 132. A plurality of heat conducting vias 134 (three are shown) connect the first heat conducting layer 130 and the second heat conducting layer 132. In various embodiments, a two-dimensional matrix of heat conducting vias would connect the first heat conducting layer and the second heat conducting layer (the two dimensions being horizontal and perpendicular to the page in FIG. 1).

As illustrated in FIG. 1, the heat conducting layers 130, 132 and the heat conducting vias 134 are all electrically isolated from the electrically conducting layers 104, 108, 112, 116 and the electrically conducting vias 120. In some instances, this electrical isolation is accomplished by the presence of a non-electrically conductive layer (e.g., a prepreg layer or the core) between a heat conducting layer and an electrically conducting layer. For example, in FIG. 1, the top prepreg layer 106 is between the first heat conducting layer 130 and first top electrically conducting layer 104 and the bottom prepreg layer 114 is between the second heat conducting layer 132 and second bottom electrically conducting layer 116. In other instances, this electrical isolation is accomplished by physical separation between the heat conducting elements (layers and vias) and the electrically conducting elements (layers and vias). For example, in FIG. 1, the electrically conducting vias 120 pass through corresponding holes in the second heat conducting layer 132, and the heat conducting vias 134 pass through corresponding holes in the first top electrically conducting layer 104, with physical separation between the elements to provide electrical isolation.

During operation of the PCB 100, at least some of the heat generated by the electronic component 122 is transferred through the conductive adhesive 124 to the first heat conducting layer 130, as indicated by arrow A.

At least some of the heat transferred to the first heat conducting layer 130 is transferred through the top prepreg layer 106 to the first top electrically conducting layer 104, as indicated by arrows B.

At least some of the heat transferred to the first top electrically conducting layer 104 is transferred by the electrically conducting vias 120 to second bottom electrically conducting layer 116, as indicated by arrows C.

At least some of the heat transferred to the first heat conducting layer 130 is transferred by the heat conducting vias 134 to the second heat conducting layer 132, as indicated by arrows D.

At least some of the heat transferred to the second heat conducting layer 132 is transferred through the bottom prepreg layer 114 to the second bottom electrically conducting layer 116, as indicated by arrows E.

At least some of the heat transferred to the second heat conducting layer 132 is transferred upward through the core 102 to the first top electrically conducting layer 104, as indicated by arrows F. At least some of the heat that is transferred from the second heat conducting layer 132 upward through the core 102 to the first top electrically conducting layer 104 is then further transferred by the electrically conducting vias 120 to the second bottom electrically conducting layer 116, as indicated by arrows C.

At least some of the heat transferred into the second bottom electrically conducting layer 116, as indicated by arrows C and E, is further transferred through the bottom solder mask 118 and out of the PCB 100 (optionally into a metallic heat sink (not illustrated)), as indicated by arrows G.

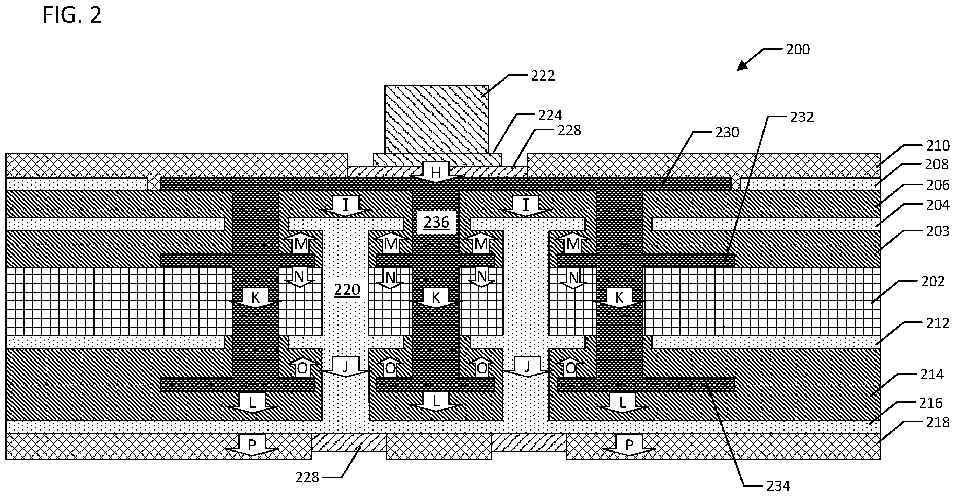

A PCB of various embodiments of the disclosure may have more than two heat conducting layers. Referring now to FIG. 2, a PCB with three heat conducting layers is illustrated. As will the PCB 100 of FIG. 1, all of the heat conducting layers of the PCB of FIG. 2 are electrically isolated from all of the electrically conducting layers. This electrical isolation between the heat conducting layers and the electrically conducting layers ensures that the electronic component is properly isolated. FIG. 2 illustrates a cross-sectional view of an example PCB, in accordance with some alternative embodiments of the present disclosure. As seen in FIG. 2, an example PCB 200 comprises a core layer (or simply "core") 202, a first top prepreg layer 203, a first top electrically conducting layer 204, a second top prepreg layer 206, a second top electrically conducting layer 208, a top solder mask 210, a first bottom electrically conducting layer 212, a bottom prepreg layer 214, a second bottom electrically conducting layer 216, and a bottom solder mask 218. In various embodiments, more or fewer layers may be present. In various embodiments, the layers may be in a different order than is illustrated. In various embodiments, the core 202 comprises any suitable material, such as FR4. In various embodiments, the prepreg layers 203, 206, 214 comprise any suitable material, such as fiberglass impregnated with resin. In various embodiments the electrically conducting layers 204, 208, 212, 216 comprise any suitable conductive material, such as copper. In various embodiments the electrically conducting layers 204, 208, 212, 216 carry electrical signals and/or provide a ground plane. Two or more of the electrically conducting layers may be connected to each other using one or more vias. In the illustrated embodiment, there are two vias 220 connecting electrically conducting layer 204 to electrically conducting layer 216. As described further below, heat may be conducted within the PCB 200 through these vias 220.

As illustrated in FIG. 2, the bottom solder mask 218 may be etched away in one or more locations to expose the second bottom electrically conducting layer 216. In such areas, a protective plating 228 (e.g., nickel or gold) is applied over the exposed areas of the electrically conducting layers. As illustrated in FIG. 2, the top solder mask 210 is etched away to expose the first heat conducting layer 230 (discussed below). The protective plating 228 is applied over this area as well.

As illustrated in FIG. 2, an electronic component 222 is mounted to a top surface of the PCB 200 (using, e.g., solder or a conductive adhesive). In various embodiments, the electronic component 222 comprises an LED, VCSEL, or the like which requires heat be dissipated through its bottom side (e.g, cathode pad, not visible in FIG. 2) and which must be electrically isolated from the ground planes of the PCB 200In various embodiments, the electronic component 222 is secured to the PCB 200 using a conductive adhesive 224 (or a conductive solder) which provides both an electrical and a thermal interface between the electronic component 222 and the PCB 200. In various embodiments, heat generated in the electronic component 222 is conducted through the cathode pad and through the conductive adhesive 224 to the heat conducting layers (described further below). As illustrated in FIG. 2, the PCB 200 comprises a first heat conducting layer 230, a second heat conducting layer 232, and a third heat conducting layer 234. A plurality of heat conducting vias 236 (three are shown) connect the first heat conducting layer 230, the second heat conducting layer 232, and the third heat conducting layer 234. (Alternatively, the plurality of heat conducting vias 236 could be considered to be a first plurality of heat conducting vias connecting the first heat conducting layer 230 and the second heat conducting layer 232 and a second plurality of heat conducting vias connecting the second heat conducting layer 232 and the third heat conducting layer 234. In such an embodiment, the first plurality of heat conducting vias and the second plurality of heat conducting vias are not necessarily vertically aligned as shown in FIG. 2.) In various embodiments, a two-dimensional matrix of heat conducting vias would connect the first heat conducting layer and the second heat conducting layer and connect the second heat conducting layer and the third heat conducting layer (the two dimensions being horizontal and perpendicular to the page in FIG. 2).

As illustrated in FIG. 2, the heat conducting layers 230, 232, 234 and the heat conducting vias 236 are all electrically isolated from the electrically conducting layers 204, 208, 212, 216 and the electrically conducting vias 220. In some instances, this electrical isolation is accomplished by the presence of a non-electrically conductive layer (e.g., a prepreg layer) between a heat conducting layer and an electrically conducting layer. For example, in FIG. 2, the second top prepreg layer 206 is between the first heat conducting layer 230 and first top electrically conducting layer 204, the first top prepreg layer 203 is between the first top electrically conducting layer 204 and the second heat conducting layer 232, and the bottom prepreg layer 214 is between the first bottom electrically conducting layer 212 and the third heat conducting layer 234 and between the third heat conducting layer 234 and the bottom solder mask 218.

In other instances, this electrical isolation is accomplished by physical separation between the heat conducting elements (layers and vias) and the electrically conducting elements (layers and vias). For example, in FIG. 2, the electrically conducting vias 220 pass through corresponding holes in the second heat conducting layer 232 and the third heat conducting layer 234, and the heat conducting vias 236 pass through corresponding holes in the first top electrically conducting layer 204 and the first bottom electrically conducting layer 212, with physical separation between the elements to provide electrical isolation.

During operation of the PCB 200, at least some of the heat generated by the electronic component 222 is transferred through the conductive adhesive 124 to the first heat conducting layer 230, as indicated by arrow H.

At least some of the heat transferred to the first heat conducting layer 230 is transferred through the second top prepreg layer 206 to the first top electrically conducting layer 204, as indicated by arrows I.

At least some of the heat transferred to the first top electrically conducting layer 204 is transferred by the electrically conducting vias 220 to second bottom electrically conducting layer 216, as indicated by arrows J.

At least some of the heat transferred to the first heat conducting layer 230 is transferred by the heat conducting vias 236 to the second heat conducting layer 232 and to the third heat conducting layer 234, as indicated by arrows K.

At least some of the heat transferred to the third heat conducting layer 234 is transferred through the bottom prepreg layer 214 to the second bottom electrically conducting layer 216, as indicated by arrows L.

At least some of the heat transferred to the second heat conducting layer 232 is transferred upward through the first top prepreg layer 203 to the first top electrically conducting layer 204, as indicated by arrows M. At least some of the heat that is transferred from the second heat conducting layer 232 upward through the first top prepreg layer 203 to the first top electrically conducting layer 204 is then further transferred by the electrically conducting vias 220 to the second bottom electrically conducting layer 216, as indicated by arrows J.

At least some of the heat transferred to the second heat conducting layer 232 is transferred downward through the core 202 to the first bottom electrically conducting layer 212 as indicated by arrows N. At least some of the heat that is transferred from the second heat conducting layer 232 downward through the core 202 to the first bottom electrically conducting layer 212 is then further transferred by the electrically conducting vias 220 to the second bottom electrically conducting layer 216, as indicated by arrows J.

At least some of the heat transferred to the third heat conducting layer 234 is transferred upward through the bottom prepreg layer 214 to the first bottom electrically conducting layer 212, as indicated by arrows O. At least some of the heat that is transferred from the third heat conducting layer 234 upward through the bottom prepreg layer 214 to the first bottom electrically conducting layer 212 is then further transferred by the electrically conducting vias 220 to the second bottom electrically conducting layer 216, as indicated by arrows J.

At least some of the heat transferred into the third bottom electrically conducting layer 234, as indicated by arrows J and L, is further transferred through the bottom solder mask 218 and out of the PCB 200 (optionally into a metallic heat sink (not illustrated)), as indicated by arrows P.

As seen in FIGS. 1 and 2, a PCB of embodiments of the present disclosure has significantly more surface area and avenues of heat transfer and therefore greater and more effective heat transfer, as compared to other approaches that have been used. By improving the thermal conductivity of the substrate, the use of expensive ceramic interposers can be avoided and smaller package outlines can be achieved while still meeting the isolation requirements for electrical design and safety. Various embodiments of the invention may be used with any electronic device having a PCB with an electronic component that requires heat dissipation and electrical isolation.

### Conclusion

Many modifications and other embodiments of the disclosures set forth herein will come to mind to one skilled in the art to which these disclosures pertain having the benefit of teachings presented in the foregoing descriptions and the associated drawings. Although the figures only show certain components of the apparatus and systems described herein, it is understood that various other components may be used in conjunction with the system. Therefore, it is to be understood that the disclosures are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above.

The section headings herein shall not limit or characterize the disclosure(s) set out in any claims that may issue from this disclosure.

While this detailed description has set forth some embodiments of the present disclosure, the appended claims cover other embodiments of the present disclosure which differ from the described embodiments according to various modifications and improvements. For example, the appended claims can cover any form of electronic device which has a PCB with an electronic component that requires heat dissipation and electrical isolation, such as but not limited to VCSEL/LED based photonic sensors. An example might be in voltage regulator circuits where transistors and/or diodes use package leads as a means of dissipating heat. Another example might be in audio circuits where transistors often use metal can packaging. In many cases these package leads and metal cans must be isolated from ground, but the ground path is by far the most efficient for dispersing heat.

## Claims

1. A printed circuit board (100; 200) comprising:
a core layer (102; 202);
a plurality of prepreg layers (106, 114; 203, 206, 214);
a plurality of electrically conducting layers (104, 108, 112, 116; 204, 208, 212, 216) for carrying electrical signals and/or for providing a ground plane;
a first heat conducting layer (130; 230) positioned to receive heat dissipated from one or more components (122; 222) attached to a surface of the printed circuit board (100; 200), the first heat conducting layer (130; 230) being electrically isolated from all of the plurality of electrically conducting layers (104, 108, 112, 116; 204, 208, 212, 216);
a second heat conducting layer (132; 232) positioned on an opposite side of one of the plurality of electrically conducting layers (104, 108, 112, 116; 204, 208, 212, 216) from the first heat conducting layer (130; 230), the second heat conducting layer (132; 232) being electrically isolated from all of the plurality of electrically conducting layers (104, 108, 112, 116; 204, 208, 212, 216); and
a first plurality of heat conducting vias (134; 236), each of the first plurality of heat conducting vias (134; 236) connected between the first heat conducting layer (130; 230) and the second heat conducting layer (132; 232), each of the first plurality of heat conducting vias (134; 236) being electrically isolated from all of the plurality of electrically conducting layers (104, 108, 112, 116; 204, 208, 212, 216).

2. The printed circuit board (100; 200) of claim 1, wherein the first (130; 230) and second (132; 232) heat conducting layers are each electrically isolated from all of the plurality of electrically conducting layers (104, 108, 112, 116; 204, 208, 212, 216) by the core layer (102; 202) and/or one or more of the plurality of prepreg layers (106, 114; 203, 206, 214).

3. The printed circuit board (100; 200) of claim 1 or claim 2, wherein at least some of the first plurality of heat conducting vias (134, 236) extend through corresponding holes defined in one or more of the plurality of electrically conducting layers (104, 108, 112, 116; 204, 208, 212, 216).

4. The printed circuit board (100; 200) of any of claims 1 to 3, further comprising a third heat conducting layer (234) positioned on an opposite side of a second one of the plurality of electrically conducting layers (104, 108, 112, 116; 204, 208, 212, 216) from the second heat conducting layer (132; 232), the third heat conducting layer (234) being electrically isolated from all of the plurality of electrically conducting layers (104, 108, 112, 116; 204, 208, 212, 216); and
a second plurality of heat conducting vias (236), each of the second plurality of heat conducting vias (236) connected between the second heat conducting layer (132; 232) and the third heat conducting layer (234), each of the second plurality of heat conducting vias (236) being electrically isolated from all of the plurality of electrically conducting layers (104, 108, 112, 116; 204, 208, 212, 216).

5. The printed circuit board (100; 200) of claim 4, wherein the second (132; 232) and third (234) heat conducting layers are each electrically isolated from all of the plurality of electrically conducting layers (104, 108, 112, 116; 204, 208, 212, 216) by the core layer (102; 202) and/or one or more of the plurality of prepreg layers (106, 114; 203, 206, 214).

6. The printed circuit board (100; 200) of claim 4 or claim 5, wherein at least some of the second plurality of heat conducting vias (236) extend through corresponding holes defined in one or more of the plurality of electrically conducting layers (104, 108, 112, 116; 204, 208, 212, 216).

7. The printed circuit board (100; 200) of any of the previous claims, further comprising:
a plurality of electrically conducting vias (120; 220) connected between corresponding ones of the plurality of electrically conducting layers (104, 108, 112, 116; 204, 208, 212, 216);
wherein at least some of the plurality of electrically conducting vias (120; 220) extend through corresponding holes defined in the second heat conducting layer (132; 232).

8. A method of manufacturing a printed circuit board (100; 200), the method comprising:
forming a stack comprising a core layer (102; 202), a plurality of prepreg layers (106, 114; 203, 206, 214), and a plurality of electrically conducting layers (104, 108, 112, 116; 204, 208, 212, 216) for carrying electrical signals and/or for providing a ground plane;
forming a first heat conducting layer (130; 230) within the stack such that the first heat conducting layer (130; 230) receives heat dissipated from one or more components (122; 222) attached to a surface of the printed circuit board (100; 200) and such that the first heat conducting layer (130; 230) is electrically isolated from all of the plurality of electrically conducting layers (104, 108, 112, 116; 204, 208, 212, 216);
forming a second heat conducting layer (132; 232) within the stack on an opposite side of one of the plurality of electrically conducting layers (104, 108, 112, 116; 204, 208, 212, 216) from the first heat conducting layer (130; 230) and such that the second heat conducting layer (132; 232) is electrically isolated from all of the plurality of electrically conducting layers (104, 108, 112, 116; 204, 208, 212, 216); and
forming a first plurality of heat conducting vias (134; 236) connected between the first heat conducting layer (130; 230) and the second heat conducting layer (132; 232), such that each of the first plurality of heat conducting vias (134; 236) are electrically isolated from all of the plurality of electrically conducting layers (104, 108, 112, 116; 204, 208, 212, 216).

9. The method of claim 8, wherein the first (130; 230) and second (132; 232) heat conducting layers are each electrically isolated from all of the plurality of electrically conducting layers (104, 108, 112, 116; 204, 208, 212, 216) by the core layer (102; 202) and/or one or more of the plurality of prepreg layers (106, 114; 203, 206, 214).

10. The method of claim 8 or claim 9, wherein at least some of the first plurality of heat conducting vias (134; 236) extend through corresponding holes defined in one or more of the electrically conducting layers (104, 108, 112, 116; 204, 208, 212, 216).

11. The method of any of claims 8 to 10, further comprising:
forming a third heat conducting layer (234) within the stack on an opposite side of a second one of the plurality of electrically conducting layers (104, 108, 112, 116; 204, 208, 212, 216) from the second heat conducting layer (132; 232) and such that the third heat conducting layer (234) is electrically isolated from all of the plurality of electrically conducting layers(104, 108, 112, 116; 204, 208, 212, 216); and
forming a second plurality of heat conducting vias (236) connected between the second heat conducting layer (132; 232) and the third heat conducting layer (234), such that each of the second plurality of heat conducting vias (236) are electrically isolated from all of the plurality of electrically conducting layers (104, 108, 112, 116; 204, 208, 212, 216).

12. The method of claim 11, wherein the second (132; 232) and third (234) heat conducting layers are each electrically isolated from all of the plurality of electrically conducting layers (104, 108, 112, 116; 204, 208, 212, 216) by the core layer (102; 202) and/or one or more of the plurality of prepreg layers (106, 114; 203, 206, 214).

13. The method of claim 11 or claim 12, wherein at least some of the second plurality of heat conducting vias (236) extend through corresponding holes defined in one or more of the plurality of electrically conducting layers (104, 108, 112, 116; 204, 208, 212, 216).

14. The method of any of claims 8 to 13, further comprising:
forming a plurality of electrically conducting vias (120; 220) between corresponding ones of the plurality of electrically conducting layers (104, 108, 112, 116; 204, 208, 212, 216) such that at least some of the plurality of electrically conducting vias (120; 220) extend through corresponding holes defined in the second heat conducting layer (132; 232).

15. A photonic sensor comprising:
a printed circuit board (100; 200), PCB, according to any of claims 1 to 7 having a light producing component (122; 222), preferably a light emitting diode or a vertical-cavity surface-emitting laser, mounted thereto, the PCB (100; 200) comprising:
a core layer (102; 202);
a plurality of prepreg layers (106, 114; 203, 206, 214);
a plurality of electrically conducting layers (104, 108, 112, 116; 204, **208, 212,** 216) for carrying electrical signals and/or for providing a ground plane;
a first heat conducting layer (130; 230) positioned to receive heat dissipated from the light producing component (122; 222), the first heat conducting layer (130; 230) being electrically isolated from all of the plurality of electrically conducting layers (104, 108, 112, 116; 204, 208, 212, 216);
a second heat conducting layer (132; 232) positioned on an opposite side of one of the plurality of electrically conducting layers (104, 108, 112, 116; 204, 208, 212, 216) from the first heat conducting layer (130; 230), the second heat conducting layer (132; 232) being electrically isolated from all of the plurality of electrically conducting layers (104, 108, 112, 116; 204, 208, 212, 216); and
a first plurality of heat conducting vias (134; 236), each of the first plurality of heat conducting vias (134; 236) connected between the first heat conducting layer (130; 230) and the second heat conducting layer (132; 232), each of the first plurality of heat conducting vias (134; 236) being electrically isolated from all of the plurality of electrically conducting layers (104, 108, 112, 116; 204, 208, 212, 216).
